# EUROPEAN PATENT SPECIFICATION

(11) **EP 4 530 249 B1**
(45) Date of publication and mention of the grant of the patent: **24.12.2025**
(21) Application number: 23200481.2
(22) Date of filing: 28.09.2023
(51) Int. Cl.: B81C 1/00

(54) **MICROELECTROMECHANICAL COMPONENT WITH GAP-CONTROL STRUCTURE AND A METHOD FOR MANUFACTURING IT**
MIKROELEKTROMECHANISCHES BAUELEMENT MIT SPALTSTEUERUNGSSTRUKTUR UND VERFAHREN ZU SEINER HERSTELLUNG
COMPOSANT MICROELECTROMECANIQUE A STRUCTURE DE CONTROLE D'ECART ET SON PROCEDE DE FABRICATION

(43) Date of publication of application: 02.04.2025
(73) Proprietor: Murata Manufacturing Co., Ltd., Nagaokakyo-shi, Kyoto 617-8555 (JP)
(72) Inventor: LINDROOS, Jeanette, 00560 Helsinki (FI); FUKUMITSU, Masakazu, Kyoto (JP)
(74) Representative: Boco IP Oy Ab

(56) References cited:
- US-A1- 2012 112 335
- US-A1- 2014 042 596
- US-B2- 10 927 004

## Description

### FIELD OF THE DISCLOSURE

This disclosure relates to electronic devices and more particularly to Microelectromechanical components. The present disclosure further concerns eutectic bonding of microelectromechanical components with a gap-control structure.

### BACKGROUND OF THE DISCLOSURE

Microelectromechanical systems (MEMS) are the technology of microscopic devices which combine mechanical and electrical features. MEMS devices, also called MEMS elements, can have either simple or complex structures with various moving parts. They include devices such as gyroscopes, acceleration sensors, magnetometers, and pressure sensors. MEMS devices may be fabricated from a silicon wafer by microfabrication techniques.

Electronic chips, also called dies, are prepared by manufacturing various electronic structures on a substrate and cutting the substrate into small, chip-size pieces. These chips may be MEMS devices. Several MEMS elements may be built on the same die. This allows significant cost and area reduction. Once the MEMS elements are built, they may need to be sealed in a particular environment depending on their function.

Eutectic bonding, also known as eutectic soldering, is a well-established semiconductor bonding technology that involves bonding wafers together by high pressure using a seal formed of two or more metal films which transform into a eutectic alloy at a specific temperature (eutectic temperature). Due to their easy preparation techniques and good wettability, eutectic alloys form excellent seals in electronic devices. Eutectic bonding is widely used in MEMS technology for the hermetic sealing of MEMS components. During the bonding process, at the eutectic temperature, the eutectic alloy is in a liquid phase. Because bonding process involves pressing wafers together at high pressure, in some circumstances, it may be challenging to accurately control the gap height between the bonded wafers, and thus the MEMS element cavity height, due to the softness of the liquid eutectic alloy. US 10 927 004 B2 discloses a method of bonding wafers. The method comprises providing a first wafer having a first bonding layer and a second wafer having a second bonding layer and having a spacer. The method further comprises bringing the first wafer in juxtaposition with the second wafer at a first temperature, the spacer abutting the first bonding layer, pressing the first wafer and the second wafer together, using a clamping force, until the first bonding layer and the second bonding layer abut, the spacer penetrating the first bonding layer, and bonding the first wafer to the second wafer eutectically, by forming a eutectic of at least parts of the first bonding layer and the second bonding layer and, consequently, forming a wafer composite.

### BRIEF DESCRIPTION OF THE DISCLOSURE

An object of the present disclosure is to provide a solution to the problem described above. The disclosed solution allows MEMS vertical gap height control in eutectically bonded microelectromechanical components. Examples provided in this disclosure describe ways to implement the solution. The improvement is achieved by features of the microelectromechanical component and a manufacturing method.

The object of the disclosure is achieved by an arrangement which is characterized by what is stated in the independent claims. The preferred embodiments of the disclosure are disclosed in the dependent claims.

The disclosure is based on the idea of including a structure comprising a standoff and an adjacent eutectic anchor inside the MEMS element. The standoff provides an accurate control of the MEMS gap height during the eutectic bonging of the component whereas the anchor improves the mechanical anchoring of the standoff. The structure provides new improvements of gap control and robustness of the eutectic bond in the microelectromechanical component.

### BRIEF DESCRIPTION OF THE DRAWINGS

In the following, the disclosure will be described in greater detail by means of preferred embodiments with reference to the accompanying drawings, in which
Figure 1 illustrates a bottom view of a cap wafer and a top view of a structure wafer comprising a gap-control region and a sealing region;
Figure 2a illustrates a simplified example of a bottom view of a cap wafer and a top view of a structure wafer in a microelectromechanical component. A metal layer is attached to the bottom surface of the cap wafer in the cap wafer gap-control region;
Figure 2b illustrates a sectional view of the microelectromechanical component comprising the cap wafer and the structure wafer shown in figure 2a. In this example, the standoff has a truncated pyramid shape;
Figure 2c illustrates another simplified example of a bottom view of a cap wafer and a top view of a structure wafer in a microelectromechanical component. In this example, the standoff has a pillar-like shape;
Figure 2d illustrates a sectional view of the microelectromechanical component comprising the cap wafer and the structure wafer shown in figure 2c;
Figures 3a-3c illustrate different possible shapes and positions of eutectic anchors in a microelectromechanical component;
Figures 4a-4b illustrate simplified examples of sectional views of microelectromechanical components comprising a gap-control structure. The cap wafers comprise electrically conductive vias;
Figures 5a-5f provide a simplified illustration of an example method for manufacturing a microelectromechanical component with a gap-control structure;
Figures 6a-6b illustrate a simplified example of a sectional view of a microelectromechanical component comprising a gap-control structure before and after bonding. In this example the eutectic anchor comprises a metalloid layer;
Figures 7a-7b illustrate another simplified example of a sectional view of a microelectromechanical component comprising a gap-control structure wherein the eutectic anchor comprises a metalloid layer;
Figures 8a-8b illustrate a further simplified example of a sectional view of a microelectromechanical component comprising a gap-control structure before and after bonding. The eutectic anchor comprises a metalloid layer;

### DETAILED DESCRIPTION OF THE DISCLOSURE

The disclosure describes a microelectromechanical component comprising a cap wafer and a structure wafer. The cap wafer has a top surface and a bottom surface. The top surface of the cap wafer defines a horizontal xy-plane and a vertical z-direction which is perpendicular to the xy-plane. The cap wafer comprises a cap wafer sealing region and a cap wafer gap-control region, and the cap wafer sealing region surrounds the cap wafer gap-control region. The structure wafer has a top surface and a bottom surface, and the top surface of the structure wafer is parallel to the xy-plane. The structure wafer comprises a structure wafer sealing region and a structure wafer gap-control region, and the structure wafer sealing region surrounds the structure wafer gap-control region. The cap wafer and the structure wafer are bonded to each other by a eutectic seal which connects the cap wafer sealing region to the structure wafer sealing region so that the cap wafer gap-control region is aligned with the structure wafer gap-control region along the z-axis. The microelectromechanical component further comprises a metal layer. The metal layer is located at the bottom surface of the cap wafer in the cap wafer gap-control region. The structure wafer further comprises a standoff in the structure wafer gap-control region. The standoff protrudes outward from the top surface of the structure wafer and extends along the z-direction so that it meets the metal layer. The microelectromechanical component further comprises at least one eutectic anchor attached to the top surface of the structure wafer in the structure wafer gap-control region next to the standoff. The eutectic anchor extends along the z-direction from the top surface of the structure wafer to the bottom surface of the cap wafer.

Any direction or plane which is parallel to the xy-plane defined by the cap wafer can be called horizontal. The direction which is perpendicular to the xy-plane can be called vertical direction. Expressions such as "top", "bottom", "above", "below", "up" and "down" refer in this disclosure to differences in the vertical z-coordinate. These expressions do not imply anything about how the device should be oriented with respect to the earth's gravitational field when the component is in use or when it is being manufactured.

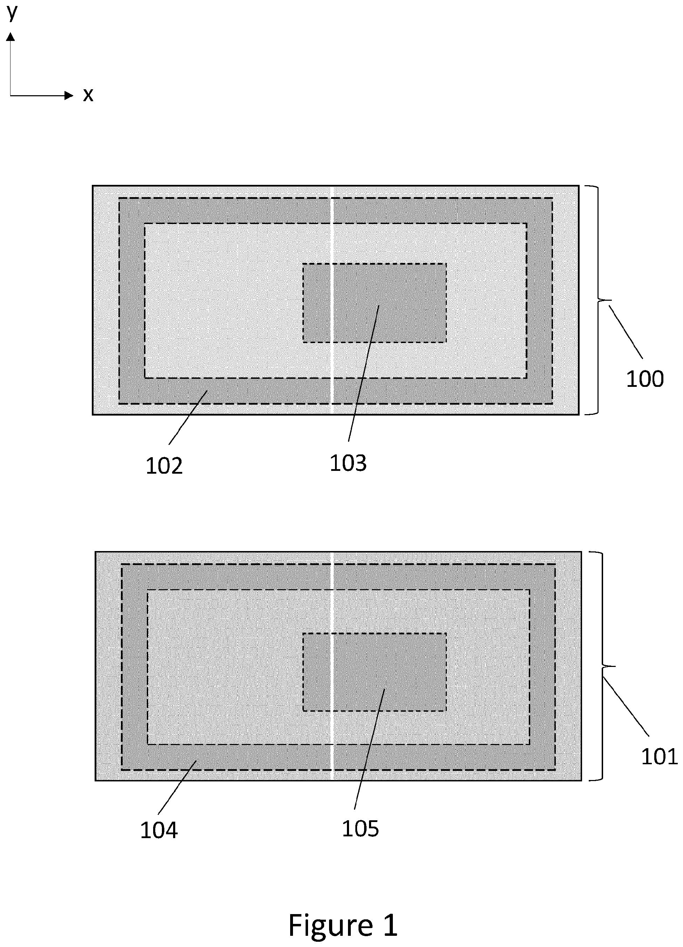

Figure 1 illustrates an example of a bottom view of a cap wafer and a top view of a structure wafer. The cap wafer 100 comprises a cap wafer gap-control region 103 and a cap wafer sealing region 102. In this example, the cap wafer sealing region 102 is adjacent to the edges of the cap wafer. The cap wafer sealing region 102 surrounds the cap wafer gap-control region 103. Similarly, the structure wafer 101 comprises a structure wafer gap-control region 105 and a structure wafer sealing region 104. In this example, the structure wafer sealing region 104 is adjacent to the edges of the structure wafer. The structure wafer sealing region 104 surrounds the structure wafer gap-control region 105. The cap wafer 100 and the structure wafer 101 may be bonded to each other so that a eutectic seal connects the cap wafer sealing region 102 to the structure wafer sealing region 104 and the cap wafer gap-control region 103 is aligned with the structure wafer gap-control region 105 along the z-axis.

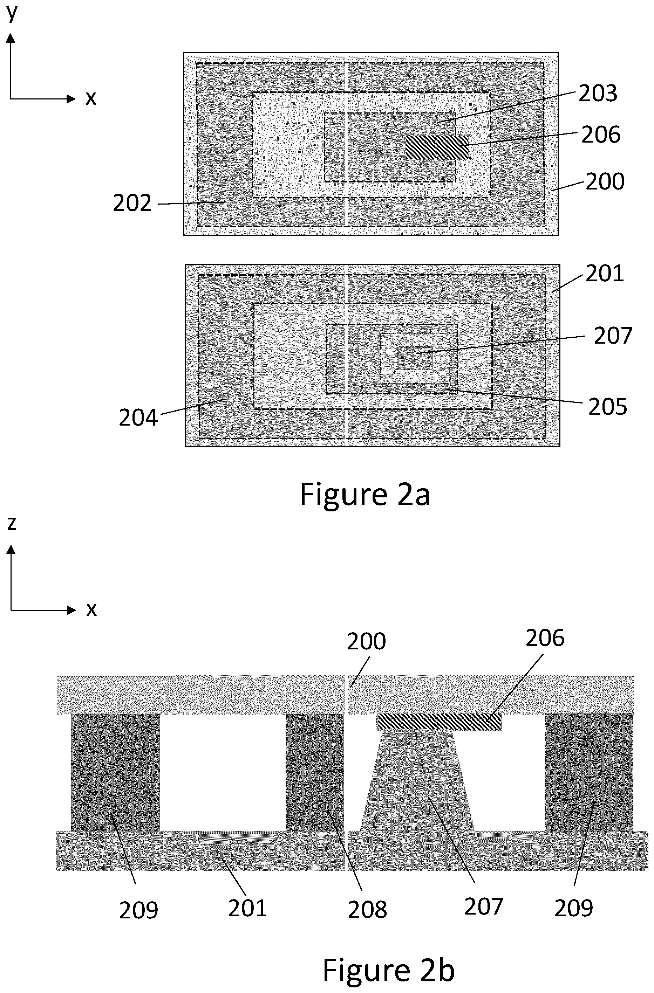

Figure 2a illustrates a simplified example of a bottom view of a cap wafer and a top view of a structure wafer in a microelectromechanical component. In this example, the cap wafer 200 comprises a cap wafer sealing region 202 which is adjacent to the edges of the cap wafer 200. The cap wafer 200 further comprises a cap wafer gap-control region 203. The cap wafer sealing region 202 surrounds the cap wafer gap-control region 203. A metal layer 206 is attached to the bottom surface of the cap wafer 200 in the cap wafer gap-control region 203. In this example, the metal layer 206 extends outside the cap wafer gap-control region. Alternatively, the metal layer may be located within the cap-wafer gap control region 203. These options may apply to any embodiment in this disclosure. The structure wafer 201 comprises a structure wafer sealing region 204. In this example, the structure wafer sealing region 204 is adjacent to the edges of the structure wafer 201. The structure wafer 201 further comprises a structure wafer gap-control region 205. The structure wafer sealing region 204 surrounds the structure wafer gap-control region 205. The structure wafer 201 further comprises a standoff 207 located in the structure wafer gap-control region 205. The standoff 207 protrudes in the z-direction outward from the top surface of the structure wafer 201. The microelectromechanical component may comprise a plurality of standoffs. The standoff shape may for example be a truncated pyramid shape, or a pillar-like shape. The pillar like-shape may be, but is not limited to, a cylinder, a hexagonal prism, or a cuboid. These options may apply to any embodiment in this disclosure. In this example, the standoff 207 has a truncated pyramid shape.

Figure 2b illustrates a sectional view of the microelectromechanical component comprising the cap wafer and structure wafer shown in figure 2a. The cap wafer 200 and the structure wafer 201 are bonded to each other by a eutectic seal 209 which connects the cap wafer sealing region to the structure wafer sealing region so that the cap wafer gap-control region is aligned with the structure wafer gap-control region along the z-axis. The standoff 207, which has a truncated pyramid shape, protrudes outward from the top surface of the structure wafer 201 and extends along the z-direction so that it meets the metal layer 206. The microelectromechanical component further comprises a eutectic anchor 208 which is attached to the top surface of the structure wafer 201 in the structure wafer gap-control region next to the standoff. The eutectic anchor 208 extends along the z-direction from the top surface of the structure wafer 201 to the bottom surface of the cap wafer 200. The distance, in any direction parallel to the xy-plane, between the eutectic anchor and the standoff may be less than the distance between the eutectic seal and the standoff. The distance, in any direction parallel to the xy-plane, between the eutectic anchor and the standoff may be in the range [5-100] µm, or [10-50] µm, or [20-80] µm, or [50-60] µm. The standoff 207 and the eutectic anchor 208 form a gap-control structure.

The metal layer 206 may be made of a variety of metals that include but are not limited to Al, Cu, Ag, Au, Pt, Pd, Mo or metal alloys. The metal layer may be formed by a variety of deposition methods such as sputtering, chemical vapor deposition, molecular beam epitaxy, electron beam physical vapor evaporation, or laser metal deposition. The thickness of the metal layer 206 may be in the range [0.1-1.0] µm, or [0.1-0.5] µm, or [0.3-0.7] µm. The eutectic anchor may be made of a eutectic alloy formed by two or more metals which include, but are not limited to, Au-Sn, Au-In or Cu-Sn. These metals may be formed by a variety of deposition methods such as sputtering, chemical vapor deposition, molecular beam epitaxy, electron beam physical vapor evaporation, or laser metal deposition. Alternatively, the eutectic anchor may be made of an alloy comprising a metalloid. For example, the eutectic anchor may be made of Ge, Al and Ti, or it may be made of Ge and Al. The eutectic anchor and eutectic seal may be made of the same eutectic alloy. Alternatively, the eutectic anchor and the eutectic seal may be made of different eutectic alloys. These options may apply to any embodiment in this disclosure.

The structure wafer may be a semiconductor device layer which has been attached to a support layer (not illustrated). The device layer may be a layer of silicon. The device layer and the support layer may for example be parts of a silicon-on-insulator (SOI) substrate where MEMS elements can be formed by patterning the top silicon layer (the device layer). The cap wafer may be an insulating wafer such as a glass layer, or a wafer comprising semiconducting parts and insulating parts, or a wafer comprising metal parts and insulating parts. These options may apply to any embodiment in this disclosure.

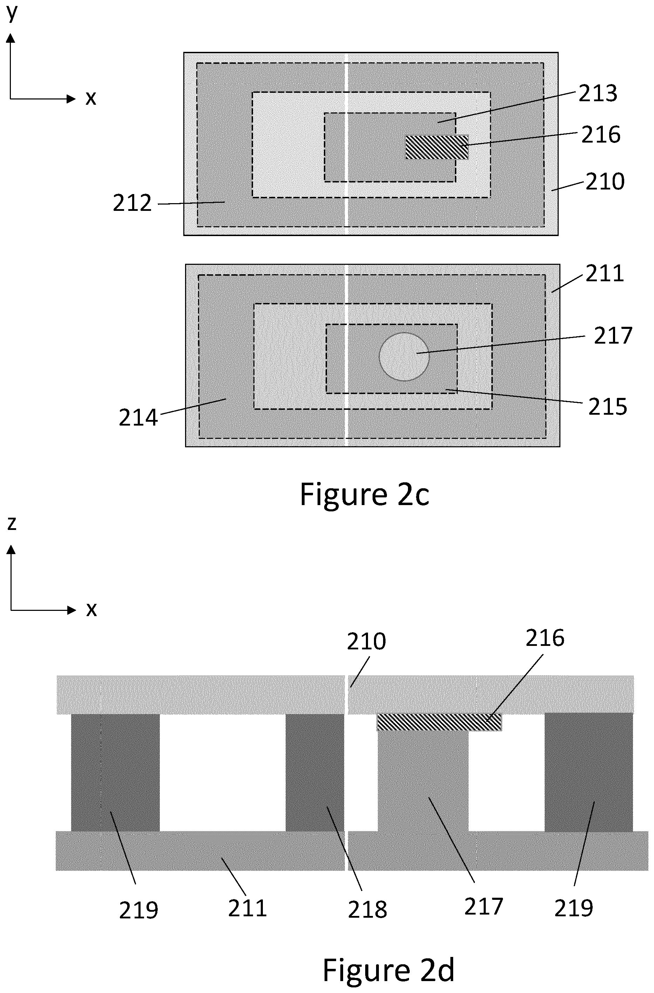

Figure 2c illustrates another simplified example of a bottom view of a cap wafer and a top view of a structure wafer in a microelectromechanical component. In this example, the standoff 217 has a pillar-like shape. Reference numbers 210, 211, 212, 213, 214, 215 and 216 in figure 2c correspond to reference numbers 200, 201, 202, 203, 204, 205 and 206, respectively, in figure 2a.

Figure 2d illustrates a sectional view of the microelectromechanical component comprising the cap wafer and structure wafer shown in figure 2c. The cap wafer 210 and the structure wafer 211 are bonded to each other by a eutectic seal 219 which connects the cap wafer sealing region to the structure wafer sealing region so that the cap wafer gap-control region is aligned with the structure wafer gap-control region along the z-axis. The standoff 217 has a cylinder shape. The microelectromechanical component further comprises a eutectic anchor 218 which is attached to the top surface of the structure wafer 211 in the structure wafer gap-control region next to the standoff. The eutectic anchor 218 extends along the z-direction from the top surface of the structure wafer 211 to the bottom surface of the cap wafer 210. The standoff 217 and the eutectic anchor 218 form a gap-control structure. Reference number 216 in figure 2d corresponds to reference number 206 in figure 2a.

The microelectromechanical component may comprise one or more eutectic anchors. A plurality of eutectic anchors may be substantially evenly distributed around the standoff. Alternatively, a single eutectic anchor may surround the standoff. The ratio of the surface area of the eutectic anchor to the surface area of the standoff in the xy-plane may be in the range [1:10-10:1] or [1:3-3:1].

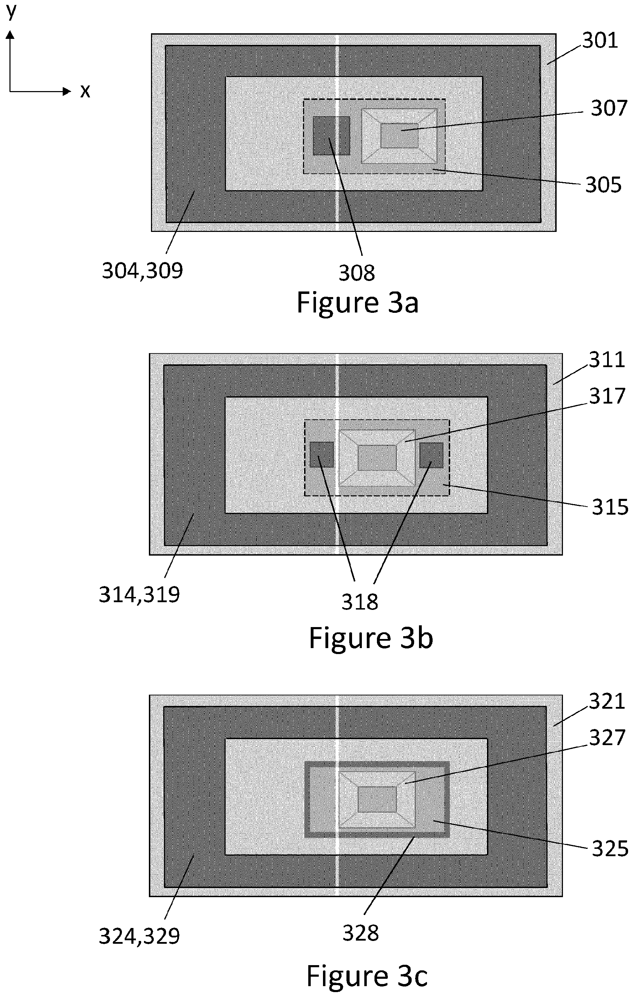

Figures 3a-3c illustrate different possible shapes and positions of eutectic anchors in a microelectromechanical component. Figure 3a illustrates an example of a simplified top view of the structure wafer 301 in a microelectromechanical component. In this example, the microelectromechanical component comprises a single eutectic anchor 308 which is adjacent to the standoff 307. Reference numbers 304 and 305 in figure 3a correspond to reference numbers 204 and 205, respectively, in figure 2a. Reference number 309 in figure 3a corresponds to reference number 209 in figure 2b.

Figure 3b illustrates another example of a simplified top view of the structure wafer in a microelectromechanical component. In this example, the microelectromechanical component comprises two eutectic anchors 318 which are adjacent to the standoff 317. The eutectic anchors 318 are located opposite to each other on different sides of the standoff 317. Reference numbers 311, 314 and 315 in figure 3b correspond to reference numbers 201, 204 and 205, respectively, in figure 2a. Reference number 319 in figure 3b corresponds to reference number 209 in figure 2b.

Figure 3c illustrates another example of a simplified top view of the structure wafer in a microelectromechanical component. In this example, the microelectromechanical component comprises one eutectic anchor 328 surrounding the standoff 327. Reference numbers 321, 324 and 325 in figure 3c correspond to reference numbers 201, 204 and 205, respectively, in figure 2a. Reference number 329 in figure 3c corresponds to reference number 209 in figure 2b.

The cap wafer may comprise at least one electrically conductive via wherein the electrically conductive via extends along the z-axis through the cap wafer so that it meets the metal layer. The electrically conductive via may extend through at least a portion of the cap wafer thickness. Alternatively, the electrically conductive via may extend through the whole cap wafer thickness.

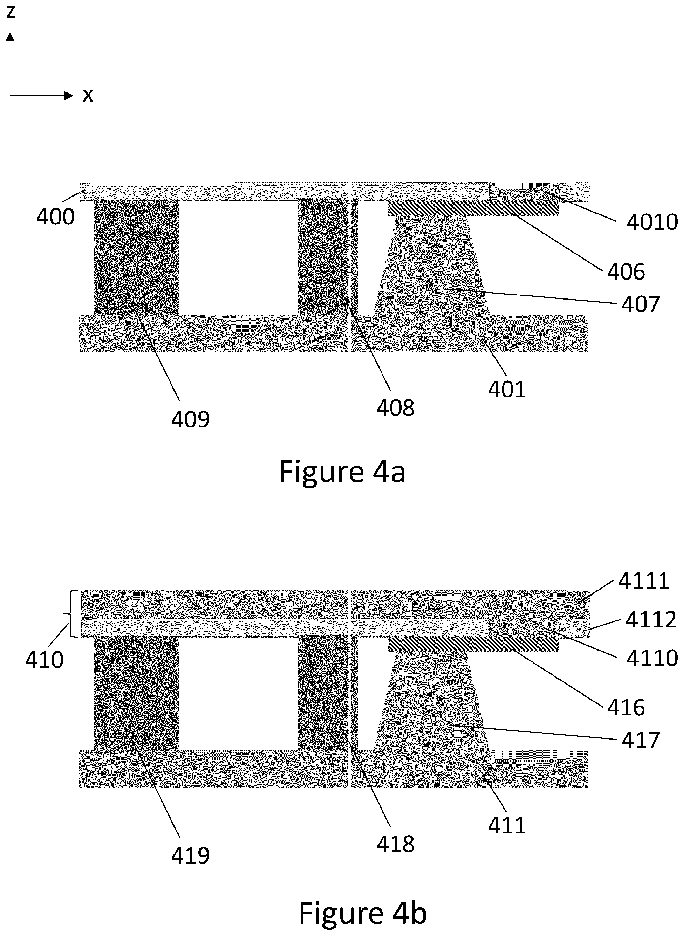

Figure 4a illustrates a simplified example of a sectional view of a microelectromechanical component comprising a gap-control structure. The microelectromechanical component comprises a cap wafer 400 and a structure wafer 401 which are bonded together via a eutectic seal 409. In this example, the cap wafer 400 comprises an electrically conductive via 4010 which extends through the whole cap wafer thickness. The microelectromechanical component further comprises a metal layer 406, which is located at the bottom side of cap wafer in the cap wafer gap-control region. The metal layer 406 extends along the bottom surface of the cap wafer so that it meets the bottom side of the electrically conductive via 4010. The cap wafer may be made of an insulating material such as glass. The electrically conductive via may be a semiconducting via. Alternatively, the electrically conductive via may be a metal via. The metal layer 406 may be connected to an external electrical connection through the electrically conductive via 4010. Reference numbers 407 and 408 in figure 4a correspond to reference numbers 207 and 208, respectively, in figure 2b.

The cap wafer may comprise a semiconducting part and an insulating part, wherein the semiconducting part is located on top of the insulating part so that the bottom surface of the insulating part forms the bottom surface of the cap wafer. The cap wafer may further comprise at least one electrically conductive via. The electrically conductive via may extend along the z-axis from the bottom side of the semiconducting part to the bottom side of the insulating part so that the insulating part surrounds the sides of the electrically conductive via. The metal layer may extend along the bottom surface of the insulating part so that it meets the bottom side of the electrically conductive via.

Alternatively, the cap wafer may comprise a metal part and an insulating part, wherein the metal part is located on top of the insulating part so that the bottom surface of the insulating part forms the bottom surface of the cap wafer. The cap wafer may further comprise at least one electrically conductive via. The electrically conductive via may extend along the z-axis from the bottom side of the metal part to the bottom side of the insulating part so that the insulating part surrounds the sides of the electrically conductive via. The metal layer may extend along the bottom surface of the insulating part so that it meets the bottom side of the electrically conductive via

Figure 4b illustrates another example of a sectional view of a microelectromechanical component with a gap-control structure. The microelectromechanical component comprises a cap wafer 410 and a structure wafer 411 which are bonded together via a eutectic seal 419. In this example, the cap wafer comprises a semiconducting part and an insulating part. The semiconducting part 4111 is located on top of the insulating part 4112 so that the bottom surface of the insulating part forms the bottom surface of the cap wafer. The cap wafer 410 further comprises an electrically conductive via 4110 which extend along the z-axis from the bottom side of the semiconducting part 4111 to the bottom side of the insulating part 4112 so that the insulating part surrounds the sides of the electrically conductive via 4110. The microelectromechanical component further comprises a metal layer 416, which is located at the bottom side of cap wafer in the cap wafer gap-control region. The metal layer 416 extends along the bottom surface of the insulating part so that it meets the bottom side of the electrically conductive via 4110. The electrically conductive via may be a semiconducting via. Alternatively, the electrically conductive via may be a metal via. The metal layer 416 may be connected to an external electrical connection through the electrically conductive via 4110. The structure wafer 411 comprises a standoff 417 which is located in the structure wafer gap-control region. The standoff 417 protrudes in the z-direction outward from the top surface of the structure wafer 411 so that it meets the metal layer 416. The standoff 417 and the metal layer 416 may serve as a good ohmic press-on contact inside the element. The standoff 417 and the adjacent eutectic anchor 418 serve as an accurate gap-height control structure as the eutectic anchor 418 contributes to securing a stable contact between the standoff 417 and the metal layer 416. In addition, the eutectic anchor adds mechanical strength to the structure making it robust to lifetime testing.

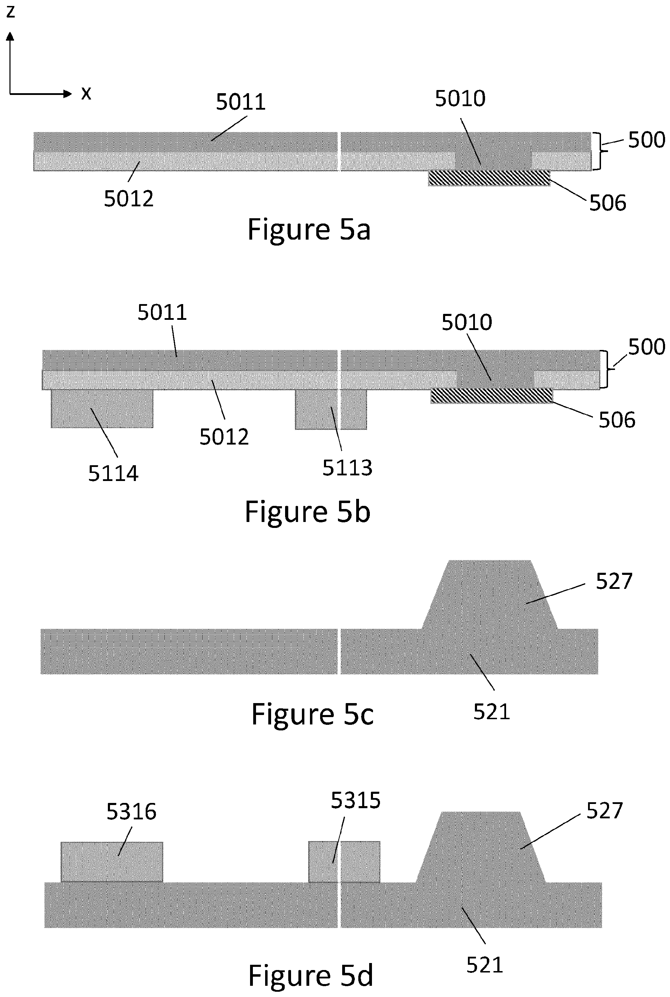

Figures 5a-5f provide a simplified illustration of an example method for manufacturing a microelectromechanical component with a gap-control structure. The microelectromechanical component comprises a cap wafer and a structure wafer. The cap wafer has a top surface and a bottom surface. The top surface of the cap wafer defines a horizontal xy-plane and a vertical z-direction which is perpendicular to the xy-plane. The cap wafer comprises a cap wafer sealing region and a cap wafer gap-control region, and the cap wafer sealing region surrounds the cap wafer gap-control region. The structure wafer has a top surface and a bottom surface. The top surface of the structure wafer is parallel to the xy-plane. The structure wafer comprises a structure wafer sealing region and a structure wafer gap-control region, and the structure wafer sealing region surrounds the structure wafer gap-control region.

The method comprises: (1) forming a first metal layer on the bottom surface of the cap wafer in the cap wafer gap-control region, (2) forming a second metal layer on the bottom surface of the cap wafer next to the first metal layer in the cap wafer gap-control region, (3) forming a standoff in the structure wafer gap-control region so that the standoff protrudes outward from the top surface of the structure wafer and extends in the z-direction, (4) forming a third metal layer on the top surface of the structure wafer next to the standoff in the structure wafer gap-control region, (5) placing the cap wafer on top of the structure wafer so that the first metal layer is aligned with the standoff along the z-axis and the second metal layer is aligned with the third metal layer along the z-axis, (6) bonding the cap wafer sealing region and the structure wafer sealing region together so that the top surface of the standoff is connected to the first metal layer, and the second metal layer and the third metal layer form a eutectic anchor. The components described above may include any structural feature which is included in the following presentation of manufacturing method.

The structure wafer may be a semiconductor device layer which has been attached to a support layer. The device layer may be a layer of silicon. The device layer and the support layer may for example be parts of a silicon-on-insulator (SOI) substrate where MEMS elements can be formed by patterning the top silicon layer (the device layer).

The method for manufacturing a microelectromechanical component with a gap-control structure may comprise the step of forming a dielectric/insulating layer on the top surface of the structure wafer before forming the third metal layer. The dielectric/insulating layer has the advantage of preventing possible chemical reactions between the eutectic anchor and the structure wafer. The dielectric/insulating layer may be an oxide or a nitride such as SiO₂, ZrO₂, HfO₂, Ta₂O₃, or SiNx. This option may apply to any embodiment in this disclosure.

The cap wafer may be an insulating wafer such as a glass layer, or a wafer comprising semiconducting parts and insulating parts, or a wafer comprising metal parts and insulating parts. The cap wafer may for example comprise a semiconducting part and an insulating part, wherein the semiconducting part is located on top of the insulating part so that the bottom surface of the insulating part forms the bottom surface of the cap wafer. The cap wafer may further comprise at least one electrically conductive via. The electrically conductive via may extend along the z-axis from the bottom side of the semiconducting part to the bottom side of the insulating part so that the insulating part surrounds the sides of the electrically conductive via. The first metal layer may extend along the bottom surface of the insulating part so that it meets the bottom side of the electrically conductive via.

Figure 5a illustrates one of the first steps of the example method for manufacturing a microelectromechanical component with a gap-control structure. In this example, the cap wafer 500 comprises a semiconducting part 5011 and an insulating part 5012. The semiconducting part 5011 is located on top of the insulating part 5012 so that the bottom surface of the insulating part forms the bottom surface of the cap wafer 500. The cap wafer 500 further comprises an electrically conductive via 5010 which extend along the z-axis from the bottom side of the semiconducting part 5011 to the bottom side of the insulating part 5012 so that the insulating part surrounds the sides of the electrically conductive via 5010. This step comprises forming a first metal layer 506 on the bottom surface of the cap wafer 500 in the cap wafer gap-control region so that the first metal layer 506 meets the bottom of the electrically conductive via 5010. The first metal layer may be made of a variety of metals that include but are not limited to Al, Cu, Ag, Au, Pt, Pd, Mo or metal alloys. The first metal layer may be formed by a variety of deposition methods such as sputtering, chemical vapor deposition, molecular beam epitaxy, electron beam physical vapor evaporation, or laser metal deposition. The thickness of the first metal layer 506 may be in the range [0.1-1.0] µm, or [0.1-0.5] µm, or [0.3-0.7] µm. The electrically conductive via may be a semiconducting via. Alternatively, the electrically conductive via may be a metal via.

Figure 5b illustrates another step in the method for manufacturing a microelectromechanical component with a gap-control structure. In this step, a second metal layer 5113 is formed on the bottom surface of the cap wafer in the cap wafer gap-control region next to the first metal layer 506. A first additional metal layer 5114 may simultaneously be formed in the cap wafer sealing region. The second metal layer 5113 and the first additional metal layer 5114 may be made of the same metal. Alternatively, the second metal layer 5113 and the first additional metal layer 5114 may be made of different metals.

Figure 5c illustrates another step in the method for manufacturing a microelectromechanical component with a gap-control structure. In this step, a standoff 527 is formed in the structure wafer gap-control region so that the standoff protrudes outward from the top surface of the structure wafer 521 and extends in the z-direction. The standoff 527 may be formed by semiconductor microfabrication techniques such as LOCOS process, wet etching process or dry etching process.

Figure 5d illustrates a further step in the method for manufacturing a microelectromechanical component with a gap-control structure. In this step, a third metal layer 5315 is formed on the top surface of the structure wafer 521 in the structure wafer gap-control region next to the standoff 527. A second additional metal layer 5316 may simultaneously be formed in the structure wafer sealing region. The third metal layer 5315 and the second additional metal layer 5316 may be made of the same metal. Alternatively, the third metal layer 5315 and the second additional metal layer 5316 may be made of different metals.

The second metal layer 5113 and the third metal layer 5315 may be made of any metals that form a eutectic alloy at a corresponding eutectic temperature. The first additional metal layer 5114 and the second additional metal layer 5316 may be made of any metals that form a eutectic alloy at a corresponding eutectic temperature. Such metals may include, but are not limited to, Au- Sn, Au-In or Cu-Sn. These options may apply to any embodiment in this disclosure.

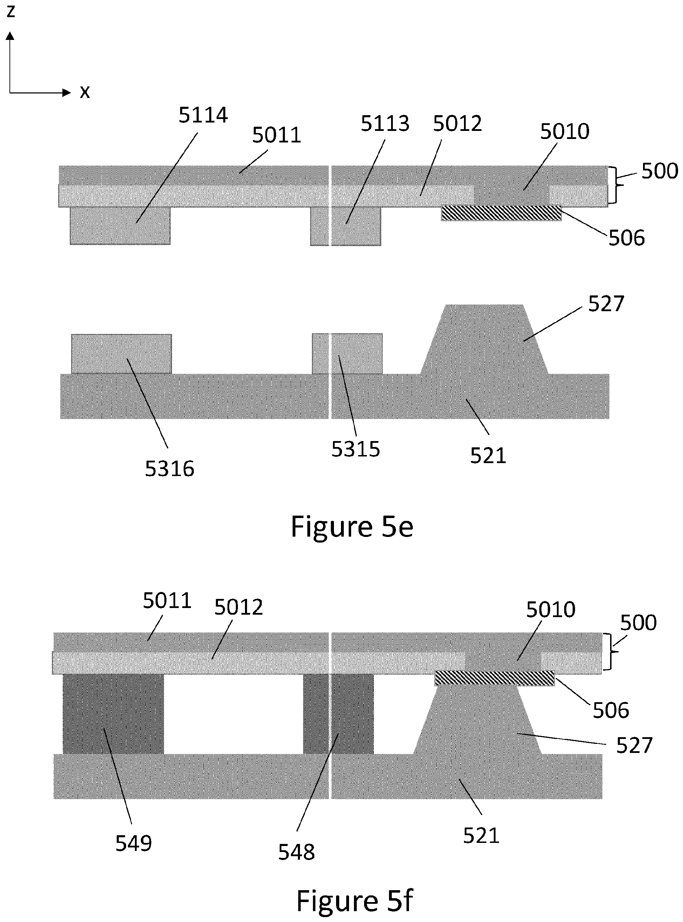

Figure 5e illustrates the step of the method for manufacturing a microelectromechanical component where the cap wafer 500 is placed on top of the structure wafer 521 so that the first metal layer 506 is aligned with the standoff 527 along the z-axis and the second metal layer 5113 is aligned with the third metal layer 5315 along the z-axis.

Figure 5f illustrates the final step of the example method for manufacturing a microelectromechanical component with a gap-control structure. In this step, the cap wafer 500 and structure wafer 521 are pressed together at a specific eutectic temperature. Consequently, the cap wafer sealing region and the structure wafer sealing region are bonded together through the eutectic seal 549 formed by the chemical reaction between the first additional metal layer 5114 and the second additional metal layer 5316. Simultaneously, the standoff 527 comes into contact with the first metal layer 506 and a eutectic anchor 548 is formed by the chemical reaction between the second metal layer 5113 and the third metal layer 5315. The eutectic temperature may be in the range [300-500]°C, [400-450]°C, or [420-450]°C.

The standoff 527 and the first metal layer 506 may serve as a good ohmic press-on contact inside the MEMS element after the eutectic bonding. The standoff 527 and the adjacent eutectic anchor 548 form an accurate gap-height control structure as the eutectic anchor 548 contributes to securing a stable contact between the standoff 527 and the first metal layer 506.

The method for manufacturing a microelectromechanical component with a gap-control structure may further comprise the steps of forming a metalloid layer on top of the third metal layer before placing the cap wafer on top of the structure wafer, then bonding the cap wafer and the structure wafer together so that the second metal layer, the third metal layer and the metalloid layer form a eutectic anchor.

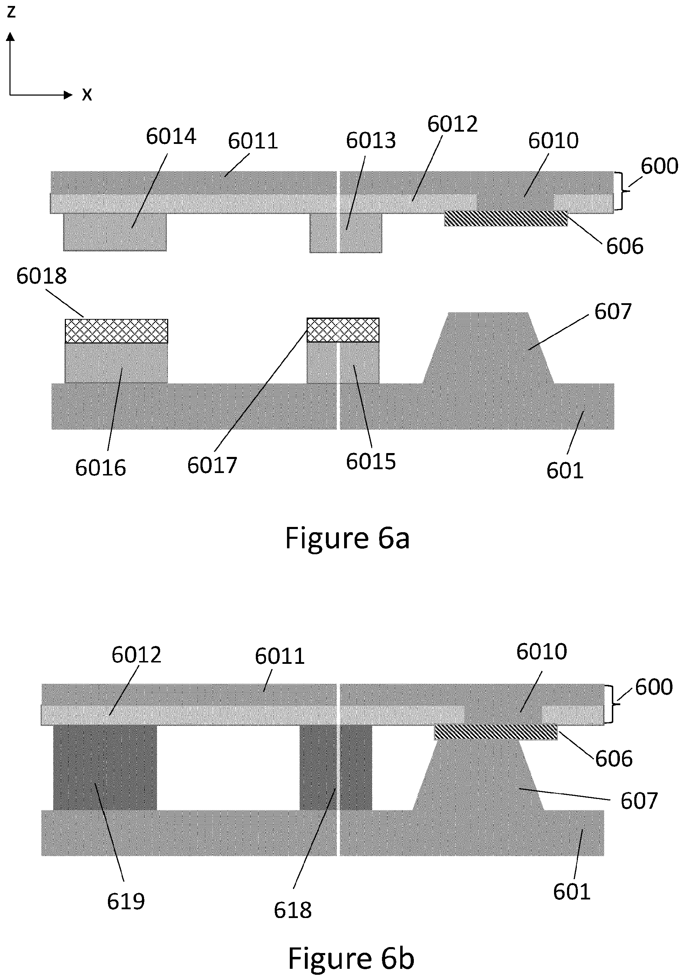

Figure 6a illustrates an example of a microelectromechanical component before the cap wafer and the structure wafer are bonded together. In this example, a metalloid layer 6017 is formed on top of the third metal layer 6015 before the eutectic bonding step. Simultaneously, an additional metalloid layer 6018 may be formed on top of the second additional metal layer 6016 before the eutectic bonding step. In such structure, the second metal layer 6013 may be an Al layer, the third metal layer 6015 may be a Ti layer, and the metalloid layer 6017 may be a Ge layer. Reference numbers, 600, 601, 606, 607, 6010, 6011, 6012 and 6014 in figure 6a correspond to reference numbers 500, 521, 506, 527, 5010, 5011, 5012 and 5114, respectively, in figure 5e.

Figure 6b illustrates the electromechanical component shown in figure 6a after the eutectic bonding of the cap wafer 600 and the structure wafer 601 together at eutectic temperature. The cap wafer sealing region and the structure wafer sealing region are bonded together through the eutectic seal 619 formed by the chemical reaction between of the first additional metal layer 6014, the second additional metal layer 6016, and the additional metalloid layer 6018. Simultaneously, the standoff 607 meets the first metal layer 606 and a eutectic anchor 618 is formed by the chemical reaction between the second metal layer 6013, the third metal layer 6015, and the metalloid layer 6017. Reference numbers 6010, 6011 and 6012 in figure 6b correspond to reference numbers 5010, 5011 and 5012, respectively, in figure 5a.

Alternatively, the method for manufacturing a microelectromechanical component may further comprise the steps of forming a metalloid layer at the bottom of the second metal layer before placing the cap wafer on top of the structure wafer, then bonding the cap wafer and the structure wafer together so that the second metal layer, the third metal layer and the metalloid layer form a eutectic anchor.

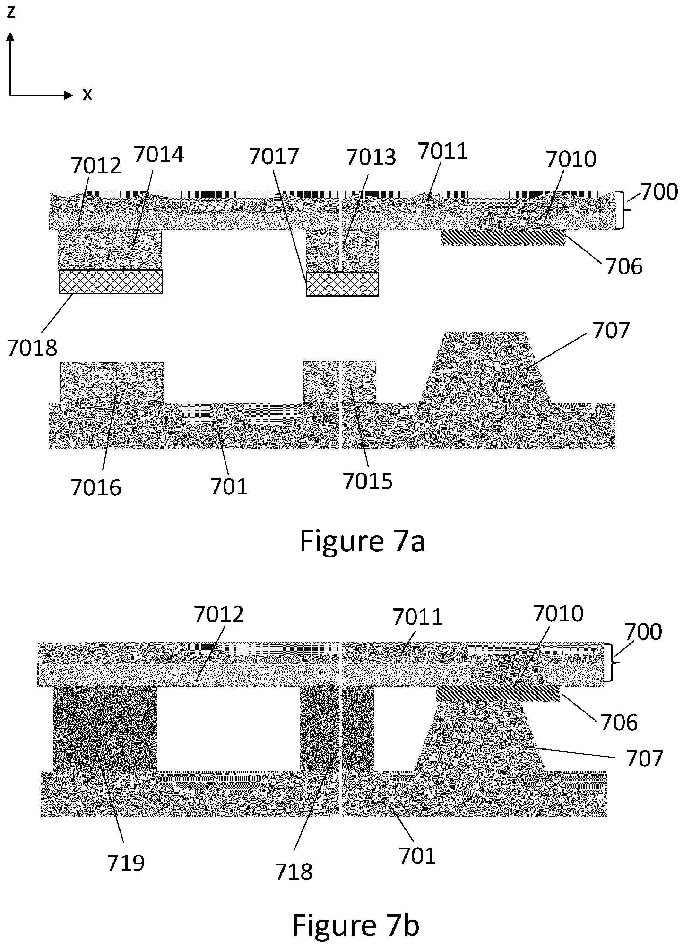

Figure 7a illustrates another example of a microelectromechanical component before the cap wafer and the structure wafer are bonded together. In this example, a metalloid layer 7017 is formed at the bottom of the second metal layer 7013 before the eutectic bonding step. Simultaneously, an additional metalloid layer 7018 may be formed at the bottom of the first additional metal layer 7014 before the eutectic bonding step. Reference numbers 700, 701, 706, 707, 7010, 7011, 7012, 7015 and 7016 in figure 7a correspond to reference numbers 500, 521, 506, 527, 5010, 5011, 5012, 5315 and 5316, respectively, in figure 5e.

Figure 7b illustrates the electromechanical component shown in figure 7a after the eutectic bonding of the cap wafer 700 and the structure wafer 701 together at eutectic temperature. The cap wafer sealing region and the structure wafer sealing region are bonded together through the eutectic seal 719 formed by the chemical reaction between of the first additional metal layer 7014, the second additional metal layer 7016, and the additional metalloid layer 7018. Simultaneously, the standoff 707 meets the first metal layer 706 and a eutectic anchor 718 is formed by the chemical reaction between the second metal layer 7013, the third metal layer 7015, and the metalloid layer 7017. The second metal layer may be a Ti layer, the third metal layer may be an Al layer, and the metalloid layer may be a Ge layer. Reference numbers 7010, 7011 and 7012 in figure 7b correspond to reference numbers 5010, 5011 and 5012, respectively, in figure 5a.

Alternatively, the eutectic anchor may be made of a eutectic alloy comprising only one metal layer and one metalloid layer such as an Al-Ge eutectic alloy. In such embodiments, the metalloid layer may be formed either on the top surface of the structure wafer or on the bottom surface of the cap wafer. Similarly, the eutectic seal may be made of a eutectic alloy comprising only one metal layer and one metalloid layer.

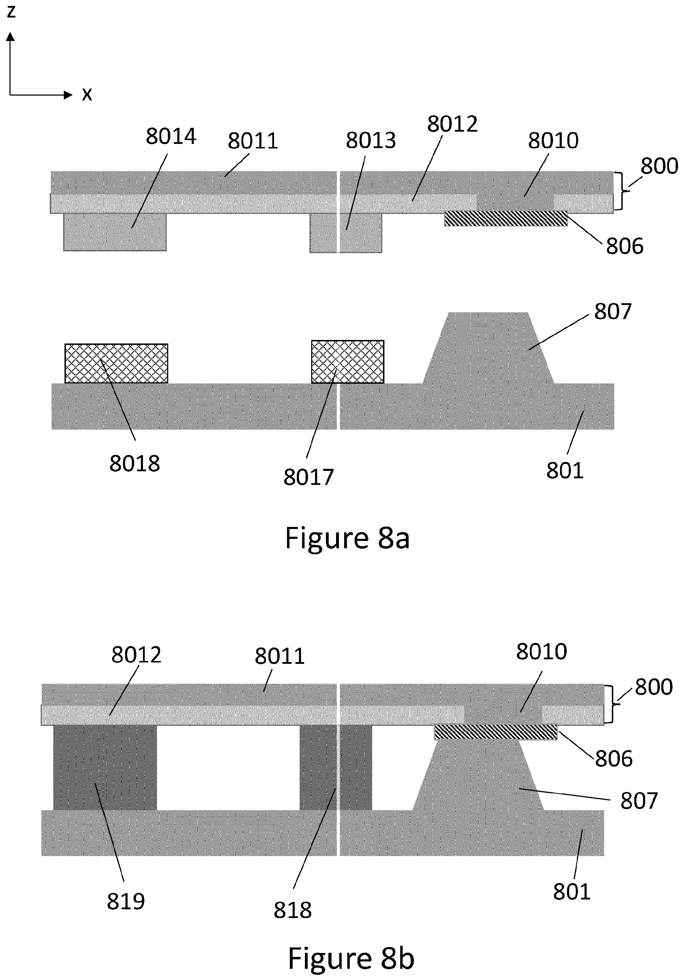

Figure 8a illustrates a simplified example of a sectional view of a microelectromechanical component comprising a gap-control structure before and after bonding. In this example the metalloid layer 8017 is formed on the top surface of the structure wafer 801 next to the standoff 807 in the structure wafer gap-control region. An additional metalloid layer 8018 may simultaneously be formed on the top surface of the structure wafer in the structure wafer sealing region. Reference numbers 800, 806, 8010, 8011, 8012, 8013 and 8014 in figure 8a correspond to reference 500, 506, 5010, 5011, 5012, 5113 and 5114, respectively, in figure 5b.

Figure 8b illustrates the electromechanical component shown in figure 8a after the eutectic bonding of the cap wafer 800 and the structure wafer 801 together at eutectic temperature. In this example, the cap wafer sealing region and the structure wafer sealing region are bonded together through the eutectic seal 819 formed by the chemical reaction between of the first additional metal layer 8014 and the additional metalloid layer 8018. Simultaneously, the standoff 807 comes into contact with the first metal layer 806 and a eutectic anchor 818 is formed by the chemical reaction between the second metal layer 8013 and the metalloid layer 8017. Reference numbers 8010, 8011 and 8012 in figure 8b correspond to reference numbers 5010, 5011 and 5012, respectively, in figure 5a.

## Claims

1. A microelectromechanical component comprising a cap wafer (100, 200, 210) and a structure wafer (101, 201, 211),
wherein the cap wafer has a top surface and a bottom surface, and the top surface of the cap wafer defines a horizontal xy-plane and a vertical z-direction which is perpendicular to the xy-plane, and wherein the cap wafer comprises a cap wafer sealing region (102, 202) and a cap wafer gap-control region (103, 203), and the cap wafer sealing region surrounds the cap wafer gap-control region,
and wherein the structure wafer (101, 201, 211) has a top surface and a bottom surface, and the top surface of the structure wafer is parallel to the xy-plane, and wherein the structure wafer comprises a structure wafer sealing region (104, 204) and a structure wafer gap-control region (105, 205), and the structure wafer sealing region surrounds the structure wafer gap-control region,
and wherein the cap wafer (100, 200, 210) and the structure wafer (101, 201, 211) are bonded to each other by a eutectic seal (209, 219) which connects the cap wafer sealing region (102, 202) to the structure wafer sealing region (104, 204) so that the cap wafer gap-control region (103, 203) is aligned with the structure wafer gap-control region (105, 205) along the z-axis,
wherein
the microelectromechanical component further comprises a metal layer (206, 216), wherein
the metal layer is located at the bottom surface of the cap wafer (100, 200, 210) in the cap wafer gap-control region (103, 203), and the structure wafer (101, 201, 211) further comprises a standoff (207, 217) in the structure wafer gap-control region, wherein the standoff protrudes outward from the top surface of the structure wafer (101, 201, 211) and extends along the z-direction so that it meets the metal layer,
and wherein the microelectromechanical component further comprises at least one eutectic anchor (208, 218) attached to the top surface of the structure wafer in the structure wafer gap-control region next to the standoff (207, 217), wherein the eutectic anchor extends along the z-direction from the top surface of the structure wafer (101, 201, 211) to the bottom surface of the cap wafer (100, 200, 210).

2. A microelectromechanical component according to claim 1, wherein the eutectic anchor (208, 218) is made of an alloy comprising a metalloid.

3. A microelectromechanical component according to claims 2, wherein the eutectic anchor (208, 218) is made of Ge, Al, and Ti.

4. A microelectromechanical component according to claims 2, wherein the eutectic anchor (208, 218) is made of Ge and Al.

5. A microelectromechanical component according to any of claims 1-4, wherein the cap wafer (400, 410) comprises at least one electrically conductive via (4010, 4110), wherein the electrically conductive via extend along the z-axis through the cap wafer so that it meets the metal layer (406, 416).

6. A microelectromechanical component according to claim 5, wherein the electrically conductive via (4010, 4110) is a semiconducting via.

7. A microelectromechanical component according to claim 5, wherein the electrically conductive via (4010, 4110) is a metal via.

8. A method for manufacturing a microelectromechanical component with a gap-control structure, wherein the microelectromechanical component comprises a cap wafer (500, 600, 700, 800) and a structure wafer (521, 601, 701, 801),
and wherein the cap wafer has a top surface and a bottom surface, and the top surface of the cap wafer defines a horizontal xy-plane and a vertical z-direction which is perpendicular to the xy-plane, and wherein the cap wafer comprises a cap wafer sealing region and a cap wafer gap-control region, and the cap wafer sealing region surrounds the cap wafer gap-control region,
and wherein the structure wafer (521, 601, 701, 801) has a top surface and a bottom surface, and the top surface of the structure wafer is parallel to the xy-plane, and wherein the structure wafer comprises a structure wafer sealing region and a structure wafer gap-control region, and the structure wafer sealing region surrounds the structure wafer gap-control region,
wherein the method comprises:
- Forming a first metal layer (506, 606, 706, 806) on the bottom surface of the cap wafer (500, 600, 700, 800) in the cap wafer gap-control region,
- Forming a second metal layer (5113, 6013, 7013, 8013) on the bottom surface of the cap wafer next to the first metal layer in the cap wafer gap-control region,
- Forming a standoff (527, 607, 707, 807) in the structure wafer gap-control region so that the standoff protrudes outward from the top surface of the structure wafer and extends in the z-direction,
- Forming a third metal layer (5315, 6015, 7015) on the top surface of the structure wafer next to the standoff in the structure wafer gap-control region,
- Placing the cap wafer (500, 600, 700, 800) on top of the structure wafer (521, 601, 701, 801) so that the first metal layer (506, 606, 706, 806) is aligned with the standoff (527, 607, 707, 807) along the z-axis and the second metal layer (5113, 6013, 7013, 8013) is aligned with the third metal layer (5315, 6015, 7015) along the z-axis,
- Bonding the cap wafer sealing region and the structure wafer sealing region together so that the top surface of the standoff is connected to the first metal layer, and the second metal layer and the third metal layer form a eutectic anchor (548, 618, 718, 818).

9. A method for manufacturing a microelectromechanical component according to claim 8, wherein the method further comprises the steps of forming a metalloid layer (6017) on top of the third metal layer (6015) before placing the cap wafer (600) on top of the structure wafer (601), then bonding the cap wafer and the structure wafer together so that the second metal layer (6013), the metalloid layer (6017), and the third metal layer (6015) form a eutectic anchor (618).

10. A method for manufacturing a microelectromechanical component according to claim 9, wherein the second metal layer (6013) is an Al layer, the third metal layer (6015) is a Ti layer, and the metalloid layer (6017) is a Ge layer.

11. A method for manufacturing a microelectromechanical component according to claim 8, wherein the method further comprises the steps of forming a metalloid layer (7017) at the bottom of the second metal layer (7013) before placing the cap wafer (700) on top of the structure wafer (701), then bonding the cap wafer and the structure wafer together so that the second metal layer, the metalloid layer, and the third metal layer form a eutectic anchor (718).

12. A method for manufacturing a microelectromechanical component according to claim 11, wherein the second metal layer (7013) is a Ti layer, the third metal layer (7015) is an Al layer, and the metalloid layer (7017) is a Ge layer.

13. A method for manufacturing a microelectromechanical component according to any of claims 8-12, wherein the cap wafer (500) comprises a semiconducting part (5011) anc an insulating part (5012), wherein the semiconducting part is located on top of the insulating part so that the bottom surface of the insulating part forms the bottom surface of the cap wafer, and wherein the cap wafer further comprises at least one electrically conductive via (5010), wherein the electrically conductive via extends along the z-axis from the bottom side of the semiconducting part to the bottom side of the insulating part so that the insulating part surrounds the sides of the electrically conductive via, and wherein the first metal layer (506) extends along the bottom surface of the insulating part (5012) so that it meets the bottom side of the electrically conductive via (5010).

## Patentansprüche

1. Mikroelektromechanisches Bauelement, das einen Deckwafer (100, 200, 210) und einen Strukturwafer (101, 201, 211) umfasst,
wobei der Deckwafer eine oberseitige Fläche und eine unterseitige Fläche aufweist und die oberseitige Fläche des Deckwafers eine horizontale xy-Ebene und eine vertikale z-Richtung, die rechtwinklig zur xy-Ebene ist, definiert, und wobei der Deckwafer eine Deckwafer-Dichtungsregion (102, 202) und eine Deckwafer-Abstandskontrollregion (103, 203) umfasst und die Deckwafer-Dichtungsregion die Deckwafer-Abstandskontrollregion umgibt,
und wobei der Strukturwafer (101, 201, 211) eine oberseitige Fläche und eine unterseitige Fläche aufweist und die oberseitige Fläche des Strukturwafers parallel zur xy-Ebene ist, und wobei der Strukturwafer eine Strukturwafer-Dichtungsregion (104, 204) und eine Strukturwafer-Abstandskontrollregion (105, 205) umfasst und die Strukturwafer-Dichtungsregion die Strukturwafer-Abstandskontrollregion umgibt,
und wobei der Deckwafer (100, 200, 210) und der Strukturwafer (101, 201, 211) über eine eutektische Dichtung (209, 219) miteinander gebondet sind, die die Deckwafer-Dichtungsregion (102, 202) mit der Strukturwafer-Dichtungsregion (104, 204) so verbindet, dass die Deckwafer-Abstandskontrollregion (103, 203) entlang der z-Achse mit der Strukturwafer-Abstandskontrollregion (105, 205) gefluchtet ist,
wobei das mikroelektromechanische Bauelement ferner eine Metallschicht (206, 216) umfasst, wobei die Metallschicht an der unterseitigen Fläche des Deckwafers (100, 200, 210) in der Deckwafer-Abstandskontrollregion (103, 203) angeordnet ist und der Strukturwafer (101, 201, 211) ferner ein Abstandselement (207, 217) in der Strukturwafer-Abstandskontrollregion umfasst, wobei das Abstandselement aus der oberseitigen Fläche des Strukturwafers (101, 201, 211) nach außen vorspringt und sich entlang der z-Richtung so erstreckt, dass es die Metallschicht erreicht,
und wobei das mikroelektromechanische Bauelement ferner mindestens einen an der oberseitigen Fläche des Strukturwafers angebrachten eutektischen Anker (208, 218) in der Strukturwafer-Abstandskontrollregion neben dem Abstandselement (207, 217) umfasst, wobei der eutektische Anker sich entlang der z-Richtung von der oberseitigen Fläche des Strukturwafers (101, 201, 211) zur unterseitigen Fläche des Deckwafers (100, 200, 210) erstreckt.

2. Mikroelektromechanisches Bauelement nach Anspruch 1, wobei der eutektische Anker (208, 218) aus einer Legierung gefertigt ist, die ein Metalloid umfasst.

3. Mikroelektromechanisches Bauelement nach Anspruch 2, wobei der eutektische Anker (208, 218) aus Ge, Al und Ti gefertigt ist.

4. Mikroelektromechanisches Bauelement nach Anspruch 2, wobei der eutektische Anker (208, 218) aus Ge und Al gefertigt ist.

5. Mikroelektromechanisches Bauelement nach einem der Ansprüche 1 bis 4, wobei der Deckwafer (400, 410) mindestens eine elektrisch leitende Durchkontaktierung (4010, 4110) umfasst, wobei die elektrisch leitende Durchkontaktierung sich entlang der z-Achse durch den Deckwafer so erstreckt, dass sie die Metallschicht (406, 416) erreicht.

6. Mikroelektromechanisches Bauelement nach Anspruch 5, wobei die elektrisch leitende Durchkontaktierung (4010, 4110) eine halbleitende Durchkontaktierung ist.

7. Mikroelektromechanisches Bauelement nach Anspruch 5, wobei die elektrisch leitende Durchkontaktierung (4010, 4110) eine metallische Durchkontaktierung ist.

8. Verfahren zur Herstellung eines mikroelektromechanischen Bauelements mit einer Abstandskontrollstruktur, wobei das mikroelektromechanische Bauelement einen Deckwafer (500, 600, 700, 800) und einen Strukturwafer (521, 601, 701, 801) umfasst, und wobei der Deckwafer eine oberseitige Fläche und eine unterseitige Fläche aufweist und die oberseitige Fläche des Deckwafers eine horizontale xy-Ebene und eine vertikale z-Richtung, die rechtwinklig zur xy-Ebene ist, definiert, und wobei der Deckwafer eine Deckwafer-Dichtungsregion und eine Deckwafer-Abstandskontrollregion umfasst und die Deckwafer-Dichtungsregion die Deckwafer-Abstandskontrollregion umgibt,
und wobei der Strukturwafer (521, 601, 701, 801) eine oberseitige Fläche und eine unterseitige Fläche aufweist und die oberseitige Fläche des Strukturwafers parallel zur xy-Ebene ist, und wobei der Strukturwafer eine Strukturwafer-Dichtungsregion und eine Strukturwafer-Abstandskontrollregion umfasst und die Strukturwafer-Dichtungsregion die Strukturwafer-Abstandskontrollregion umgibt,
wobei das Verfahren umfasst:
- Ausbilden einer ersten Metallschicht (506, 606, 706, 806) auf der unterseitigen Fläche des Deckwafers (500, 600, 700, 800) in der Deckwafer-Abstandskontrollregion,
- Ausbilden einer zweiten Metallschicht (5113, 6013, 7013, 8013) auf der unterseitigen Fläche des Deckwafers neben der ersten Metallschicht in der Deckwafer-Abstandskontrollregion,
- Ausbilden eines Abstandselements (527, 607, 707, 807) in der Strukturwafer-Abstandskontrollregion dergestalt, dass das Abstandselement aus der oberseitigen Fläche des Strukturwafers nach außen herausragt und sich in der z-Richtung erstreckt,
- Ausbilden einer dritten Metallschicht (5315, 6015, 7015) auf der oberseitigen Fläche des Strukturwafers neben dem Abstandselement in der Strukturwafer-Abstandskontrollregion,
- Auflegen des Deckwafers (500, 600, 700, 800) auf den Strukturwafer (521, 601, 701, 801) dergestalt, dass die erste Metallschicht (506, 606, 706, 806) entlang der z-Achse mit dem Abstandselement (527, 607, 707, 807) gefluchtet ist und die zweite Metallschicht (5113, 6013, 7013, 8013) entlang der z-Achse mit der dritten Metallschicht (5315, 6015, 7015) gefluchtet ist,
- Bonden der Deckwafer-Dichtungsregion und der Strukturwafer-Dichtungsregion dergestalt, dass die oberseitige Fläche des Abstandselements mit der ersten Metallschicht verbunden ist und die zweite Metallschicht und die dritte Metallschicht einen eutektischen Anker (548, 618, 718, 818) bilden.

9. Verfahren zur Herstellung eines mikroelektromechanischen Bauelements nach Anspruch 8, wobei das Verfahren ferner die Schritte umfasst: Ausbilden einer Metalloidschicht (6017) auf der dritten Metallschicht (6015), bevor der Deckwafer (600) auf den Strukturwafer (601) aufgelegt wird, dann Bonden des Deckwafers und des Strukturwafers dergestalt, dass die zweite Metallschicht (6013), die Metalloidschicht (6017) und die dritte Metallschicht (6015) einen eutektischen Anker (618) bilden.

10. Verfahren zur Herstellung eines mikroelektromechanischen Bauelements nach Anspruch 9, wobei die zweite Metallschicht (6013) eine Al-Schicht, die dritte Metallschicht (6015) eine Ti-Schicht und die Metalloidschicht (6017) eine Ge-Schicht ist.

11. Verfahren zur Herstellung eines mikroelektromechanischen Bauelements nach Anspruch 8, wobei das Verfahren ferner die Schritte umfasst: Ausbilden einer Metalloidschicht (7017) an der Unterseite der zweiten Metallschicht (7013), bevor der Deckwafer (700) auf den Strukturwafer (701) aufgelegt wird, dann Bonden des Deckwafers und des Strukturwafers dergestalt, dass die zweite Metallschicht, die Metalloidschicht und die dritte Metallschicht einen eutektischen Anker (718) bilden.

12. Verfahren zur Herstellung eines mikroelektromechanischen Bauelements nach Anspruch 11, wobei die zweite Metallschicht (7013) eine Ti-Schicht, die dritte Metallschicht (7015) eine Al-Schicht und die Metalloidschicht (7017) eine Ge-Schicht ist.

13. Verfahren zur Herstellung eines mikroelektromechanischen Bauelements nach einem der Ansprüche 8 bis 12, wobei der Deckwafer (500) einen halbleitenden Teil (5011) und einen isolierenden Teil (5012) umfasst, wobei der halbleitende Teil auf dem isolierenden Teil so angeordnet ist, dass die unterseitige Fläche des isolierenden Teils die unterseitige Fläche des Deckwafers bildet, und wobei der Deckwafer ferner mindestens eine elektrisch leitende Durchkontaktierung (5010) umfasst, wobei die elektrisch leitende Durchkontaktierung sich entlang der z-Achse von der Unterseite des halbleitenden Teils zur Unterseite des isolierenden Teils erstreckt, so dass der isolierende Teil die Seiten der elektrisch leitenden Durchkontaktierung umgibt, und wobei die erste Metallschicht (506) sich entlang der unterseitigen Fläche des isolierenden Teils (5012) so erstreckt, dass sie die Unterseite der elektrisch leitenden Durchkontaktierung (5010) erreicht.

## Revendications

1. Composant microélectromécanique comprenant une tranche de couverture (100, 200, 210) et une tranche de structure (101, 201, 211),
dans lequel la tranche de couverture a une surface supérieure et une surface inférieure, et la surface supérieure de la tranche de couverture définit un plan xy horizontal et une direction z verticale qui est perpendiculaire au plan xy, et dans lequel la tranche de couverture comprend une zone de scellement de tranche de couverture (102, 202) et une zone de contrôle d'entrefer de tranche de couverture (103, 203), et la zone de scellement de tranche de couverture entoure la zone de contrôle d'entrefer de tranche de couverture,
et dans lequel la tranche de structure (101, 201, 211) a une surface supérieure et une surface inférieure, et la surface supérieure de la tranche de structure est parallèle au plan xy, et dans lequel la tranche de structure comprend une zone de scellement de tranche de structure (104, 204) et une zone de contrôle d'entrefer de tranche de structure (105, 205), et la zone de scellement de tranche de structure entoure la zone de contrôle d'entrefer de tranche de structure,
et dans lequel la tranche de couverture (100, 200, 210) et la tranche de structure (101, 201, 211) sont assemblées l'une à l'autre par un scellement eutectique (209, 219) qui relie la zone de scellement de tranche de couverture (102, 202) à la zone de scellement de tranche de structure (104, 204) de telle sorte que la zone de contrôle d'entrefer de tranche de couverture (103, 203) est alignée sur la zone de contrôle d'entrefer de tranche de structure (105, 205) le long de l'axe z,
dans lequel le composant microélectromécanique comprend également une couche métallique (206, 216), dans lequel la couche métallique est située sur la surface inférieure de la tranche de couverture (100, 200, 210) dans la zone de contrôle d'entrefer de tranche de couverture (103, 203) et la tranche de structure (101, 201, 211) comprend également un plot d'espacement (207, 217) dans la zone de contrôle d'entrefer de tranche de structure, dans lequel le plot d'espacement fait saillie vers l'extérieur à partir de la surface supérieure de la tranche de structure (101, 201, 211) et s'étend le long de la direction z de manière à atteindre la couche métallique,
et dans lequel le composant microélectromécanique comprend également au moins un ancrage eutectique (208, 218) fixé à la surface supérieure de la tranche de structure dans la zone de contrôle d'entrefer de tranche de structure à côté du plot d'espacement (207, 217), dans lequel l'ancrage eutectique s'étend le long de la direction z de la surface supérieure de la tranche de structure (101, 201, 211) jusqu'à la surface inférieure de la tranche de couverture (100, 200, 210).

2. Composant microélectromécanique selon la revendication 1, dans lequel l'ancrage eutectique (208, 218) est fait d'un alliage comprenant un métalloïde.

3. Composant microélectromécanique selon la revendication 2, dans lequel l'ancrage eutectique (208, 218) est fait de Ge, Al et Ti.

4. Composant microélectromécanique selon la revendication 2, dans lequel l'ancrage eutectique (208, 218) est fait de Ge et Al.

5. Composant microélectromécanique selon l'une des revendications 1 à 4, dans lequel la tranche de couverture (400, 410) comprend au moins un via électriquement conducteur (4010, 4110), dans lequel le via électriquement conducteur s'étend le long de l'axe z à travers la tranche de couverture de manière à atteindre la couche métallique (406, 416).

6. Composant microélectromécanique selon la revendication 5, dans lequel le via électriquement conducteur (4010, 4110) est un via semiconducteur.

7. Composant microélectromécanique selon la revendication 5, dans lequel le via électriquement conducteur (4010, 4110) est un via métallique.

8. Procédé de fabrication d'un composant microélectromécanique avec une structure de contrôle d'entrefer, dans lequel le composant microélectromécanique comprend une tranche de couverture (500, 600, 700, 800) et une tranche de structure (521, 601, 701, 801),
et dans lequel la tranche de couverture a une surface supérieure et une surface inférieure, et la surface supérieure de la tranche de couverture définit un plan xy horizontal et une direction z verticale qui est perpendiculaire au plan xy, et dans lequel la tranche de couverture comprend une zone de scellement de tranche de couverture et une zone de contrôle d'entrefer de tranche de couverture, et la zone de scellement de tranche de couverture entoure la zone de contrôle d'entrefer de tranche de couverture,
et dans lequel la tranche de structure (521, 601, 701, 801) a une surface supérieure et une surface inférieure, et la surface supérieure de la tranche de structure est parallèle au plan xy, et dans lequel la tranche de structure comprend une zone de scellement de tranche de structure et une zone de contrôle d'entrefer de tranche de structure, et la zone de scellement de tranche de structure entoure la zone de contrôle d'entrefer de tranche de structure,
ledit procédé comprenant les étapes consistant à :
- former une première couche métallique (506, 606, 706, 806) sur la surface inférieure de la tranche de couverture (500, 600, 700, 800) dans la zone de contrôle d'entrefer de tranche de couverture,
- former une deuxième couche métallique (5113, 6013, 7013, 8013) sur la surface inférieure de la tranche de couverture à côté de la première couche métallique dans la zone de contrôle d'entrefer de tranche de couverture,
- former un plot d'espacement (527, 607, 707, 807) dans la zone de contrôle d'entrefer de tranche de structure de telle sorte que le plot d'espacement fait saillie vers l'extérieur à partir de la surface supérieure de la tranche de structure et s'étend dans la direction z,
- former une troisième couche métallique (5315, 6015, 7015) sur la surface supérieure de la tranche de structure à côté du plot d'espacement dans la zone de contrôle d'entrefer de tranche de structure,
- placer la tranche de couverture (500, 600, 700, 800) sur la tranche de structure (521, 601, 701, 801) de telle sorte que la première couche métallique (506, 606, 706, 806) est alignée sur le plot d'espacement (527, 607, 707, 807) le long de l'axe z et la deuxième couche métallique (5113, 6013, 7013, 8013) est alignée sur la troisième couche métallique (5315, 6015, 7015) le long de l'axe z,
- assembler la zone de scellement de tranche de couverture à la zone de scellement de tranche de structure de telle sorte que la surface supérieure du plot d'espacement est reliée à la première couche métallique et que la deuxième couche métallique et la troisième couche métallique forment un ancrage eutectique (548, 618, 718, 818).

9. Procédé de fabrication d'un composant microélectromécanique selon la revendication 8, ledit procédé comprenant également les étapes consistant à former une couche de métalloïde (6017) sur la troisième couche métallique (6015) avant de placer la tranche de couverture (600) sur la tranche de structure (601), puis assembler la tranche de couverture à la tranche de structure de telle sorte que la deuxième couche métallique (6013), la couche de métalloïde (6017) et la troisième couche métallique (6015) forment un ancrage eutectique (618).

10. Procédé de fabrication d'un composant microélectromécanique selon la revendication 9, dans lequel la deuxième couche métallique (6013) est une couche AI, la troisième couche métallique (6015) est une couche Ti et la couche de métalloïde (6017) est une couche Ge.

11. Procédé de fabrication d'un composant microélectromécanique selon la revendication 8, ledit procédé comprenant également les étapes consistant à former une couche de métalloïde (7017) sur la face inférieure de la deuxième couche métallique (7013) avant de placer la tranche de couverture (700) sur la tranche de structure (701), puis assembler la tranche de couverture à la tranche de structure de telle sorte que la deuxième couche métallique, la couche de métalloïde et la troisième couche métallique forment un ancrage eutectique (718).

12. Procédé de fabrication d'un composant microélectromécanique selon la revendication 11, dans lequel la deuxième couche métallique (7013) est une couche Ti, la troisième couche métallique (7015) est une couche Al et la couche de métalloïde (7017) est une couche Ge.

13. Procédé de fabrication d'un composant microélectromécanique selon l'une des revendications 8 à 12, dans lequel la tranche de couverture (500) comprend une partie semiconductrice (5011) et une partie isolante (5012), dans lequel la partie semiconductrice est située au-dessus de la partie isolante de telle sorte que la surface inférieure de la partie isolante forme la surface inférieure de la tranche de couverture, et dans lequel la tranche de couverture comprend également au moins un via électriquement conducteur (5010), ledit via électriquement conducteur s'étendant le long de l'axe z de la face inférieure de la partie semiconductrice à la face inférieure de la partie isolante de telle sorte que la partie isolante entoure les côtés du via électriquement conducteur, et dans lequel la première couche métallique (506) s'étend le long de la surface inférieure de la partie isolante (5012) de manière à atteindre la face inférieure du via électriquement conducteur (5010).
